# DEMANDE DE BREVET EUROPEEN

(11) **EP 2 816 597 A2**
(43) Date de publication de la demande: **24.12.2014**
(21) Numéro de dépôt: 14172271.0
(22) Date de dépôt: 13.06.2014
(51) Int. Cl.: H01L 23/498, H01L 21/48

(54) **Procédé de réalisation d'un dispositif microélectronique mécaniquement autonome**

(30) Priorité: 20.06.2013 FR 1355833
(71) Demandeur: COMMISSARIAT A L'ENERGIE ATOMIQUE ET AUX ENERGIES ALTERNATIVES, 75015 Paris (FR)
(72) Inventeur: Scannel, Mark, 38000 Grenoble (FR)
(74) Mandataire: Decobert, Jean-Pascal

(57) **Abrégé**

L'invention concerne un procédé de réalisation d'un dispositif microélectronique mécaniquement autonome (10) comprenant au moins un via électrique (50) autorisant une connexion électrique à partir d'au moins une première face du dispositif caractérisé en ce qu'il comprend la séquence d'étapes suivantes :
- à partir d'un premier substrat (100) comportant une première portion (51) de via électrique (50) exposée à une première face du premier substrat (100), et d'un deuxième substrat (200) comportant une deuxième portion (52) de via électrique (50) exposée à une première face du deuxième substrat (200), une étape de report du premier substrat (100) sur le deuxième substrat (200), par collage de leurs premières faces de sorte à ce que la première portion (51) et la deuxième portion (52) de via électrique (50) soient en continuité électrique,
- une étape de retrait partiel d'une partie du premier substrat (100) à partir d'une deuxième face du premier substrat (100), opposée à la première face dudit premier substrat (100), de sorte à atteindre la première portion (51) de via électrique (50).

## Description

### DOMAINE DE L'INVENTION

La présente invention est relative à l'intégration tridimensionnelle 3D, et notamment à l'intégration 2.5D plus connue sous le nom de technologie d'interposeurs. L'invention concerne plus particulièrement la réalisation d'un dispositif microélectronique mécaniquement autonome comprenant au moins un via électrique.

### ARRIERE-PLAN TECHNOLOGIQUE

En référence à la Loi de Moore, qui prédit empiriquement le doublement, tous les deux ans, de l'intégration des composants dans l'industrie électronique, les développements actuels de l'électronique sont souvent présentés comme suivant deux directions complémentaires. Une voie est celle de la miniaturisation « More Moore », qui consiste à continuellement décroître les dimensions des composants élémentaires. En parallèle, la voie de la diversification « More than Moore » définit la tendance à intégrer de plus en plus de fonctionnalités différentes dans une même puce, indépendamment du degré de miniaturisation. Les deux voies sont parallèles et regroupent un vaste ensemble de technologies et procédés qui font l'objet d'études de tous les grands acteurs de la recherche et du développement. Parmi les procédés à l'étude, figure une architecture à trois dimensions « intégration 3D », qui consiste à empiler verticalement des composants électroniques, en superposant des puces et/ou des plaques les unes sur les autres et en établissant des connexions électriques courtes entre ces composants, directement au travers des différentes couches. L'intégration 3D nécessite de maîtriser les connexions électriques entre les différentes puces empilées verticalement. Elle doit répondre à de nombreux défis, notamment la complexité de la conception, les problèmes de dissipation thermique, l'absence de normalisation, la fiabilité, la définition de stratégie de tests adaptée à des circuits empilés.

Les deux types de connectiques généralement utilisés pour amener les signaux aux entrées et sorties d'un circuit sont le câblage externe (en anglais « wire bonding ») et le report de puces retournées (en anglais « flip chip »). Dans l'optique de connecter plusieurs puces dans un même boitier de « packaging » sans opter pour la solution de câblage externe, plusieurs approches d'intégration sont disponibles. Parmi toutes ces approches d'intégration, le vecteur commun est l'utilisation de vias électriques traversants pour reporter les connexions électriques d'une première face vers une deuxième face sans passer par un câblage externe à la puce. Pour réaliser ces connexions intra-puce, deux options sont possibles. La première est d'implémenter les vias électriques traversants directement dans une des puces actives de l'empilement. La deuxième, plus communément utilisée, consiste à concevoir un dispositif microélectronique mécaniquement autonome ou substrat passif, appelé interposeur, qui relie deux puces implémentées en « sandwich » autour du dispositif. Les deux systèmes communiquent, à travers ce dernier, par un routage interne et des vias électriques traversants qui connectent la face avant et la face arrière de l'interposeur. Lorsque sur un même dispositif microélectronique mécaniquement autonome, on assemble plusieurs composants côte à côte, on parle alors d'intégration 2.5D.

Les interposeurs de silicium ont été récemment introduits dans l'industrie. Néanmoins, un certain nombre d'inconvénients rend leur utilisation difficile. En effet, les interposeurs actuels sont connus comme n'étant pas stables mécaniquement du fait de leur faible épaisseur. Ils sont, de manière générale, assez fins car possèdent des connexions électriques verticales (de type TSV de l'acronyme en anglais de « Through Silicon Via » ou encore TGV de l'acronyme en anglais de « Through Glass Via »), pour permettre de faire passer le signal électrique d'une face supérieure (« chip interconnects ») à une face inférieure (« substrate interconnects »).

Dans le cas du silicium, la technologie de pointe actuelle de fabrication permet de former des vias électriques traversants avec un facteur de forme de l'ordre de 10 pour 1. Etant donné les exigences électriques requises et le coût de remplissage des vias électriques traversants en cuivre, de nombreux acteurs de l'industrie ont convergé vers un diamètre pratique de vias électriques traversants de l'ordre de 10 microns. Avec un facteur de forme de 10 pour 1, cela signifie que la longueur des vias électriques traversants et, par conséquent, l'épaisseur des interposeurs sont généralement limitées à une valeur de 80 à 120 microns. Dans les prochaines années, nous serons amenés à cibler de plus importants rapports de forme pour les vias électriques traversants ; certaines personnes ont, par exemple, pour objectif un facteur de forme de 20 pour 1. Cependant, même avec des améliorations dans le facteur de forme, la longueur des vias électriques traversants impose la fabrication et l'utilisation d'un interposeur très fin, et par conséquent, possédant une fragilité mécanique inhérente.

Dès lors, les interposeurs de silicium ayant l'inconvénient d'être relativement fins et par conséquent mécaniquement fragiles, les mesures électriques et les tests s'avèrent de plus en plus difficile, et deviendront peut-être bientôt quasiment impossible. Les interposeurs seront probablement testés après assemblage, rendant le coût de non-conformité très élevé. Il existe peu de compagnies, à ce jour, capables de fabriquer à la fois des puces et des interposeurs. Quand il n'y a qu'un fabricant impliqué pour les puces et les interposeurs, les questions portant sur le recouvrement des coûts de non-conformité restent en interne et sont plus facile à gérer. Mais, ne sachant pas comment tester et quantifier, il devient très difficile pour deux compagnies distinctes de fabrication de s'entendre sur les termes et conditions de non-conformité. Cela signifie que la collaboration d'une compagnie fournissant la puce et d'une compagnie fournissant le substrat ne pourra désormais plus fonctionner, ce qui impactera nécessairement la chaîne de fabrication des compagnies sans unité de fabrication ainsi que les coûts de développement.

Le procédé de fabrication d'un interposeur de silicium est actuellement difficile (et, par conséquence, coûteux). Une des difficultés principales (et des coûts élevés) provient du fait que le procédé d'aujourd'hui requiert la manipulation et le traitement de plaques très fines. Des technologies élaborées de manipulation de plaques sont utilisées quand l'interposeur très fin de silicium reste attaché au substrat de silicium ou de verre par l'emploi de colle temporaire. Le collage, puis le décollage, auquel s'ensuit la manipulation de composants très fins est extrêmement difficile. Il existe une multitude de variantes de techniques de collage et décollage comme, par exemple, les techniques plus connues en anglais sous les noms de « laser release », « temperature release », « multi-layer glue », « spin-on », « laminate ». Néanmoins, l'industrie en général a été incapable de converger vers une technique de référence; chaque technique possédant des inconvénients. Quelque soit le procédé d'intégration choisi pour la fabrication d'un interposeur de silicium, le dispositif final est très fin. Parce que l'interposeur subit des contraintes différentes sur chacune de ses faces (la face supérieure et la face inférieure sont très différentes structurellement et en apparence nécessitant différents emplacements d'interconnexions), l'interposeur de silicium a tendance à se courber puis à se déformer. Plus la surface de l'interposeur est grande, pires seront la courbure et la déformation de l'interposeur.

Plus que le coût, cela représente le principal défi technique à la conception d'interposeurs aujourd'hui.

La présente invention permet de résoudre tout ou, du moins, une partie des inconvénients des techniques actuelles. L'invention permettra de réaliser un dispositif microélectronique mécaniquement stable et autonome qui sera conforme aux besoins de la chaîne de fabrication.

### RESUME DE L'INVENTION

Un aspect de l'invention est relatif à un procédé de réalisation d'un dispositif microélectronique mécaniquement autonome comprenant au moins un via électrique autorisant une connexion électrique à partir d'au moins une première face du dispositif.

Selon l'invention, le procédé de réalisation comprend la séquence d'étapes suivantes :
- à partir d'un premier substrat comportant une première portion de via électrique exposée à une première face du premier substrat, et d'un deuxième substrat comportant une deuxième portion de via électrique exposée à une première face du deuxième substrat, une étape d'assemblage des premier et deuxième substrats par collage de leurs premières faces de sorte à ce que la première portion et la deuxième portion de via électrique soient en continuité électrique,
- une étape de retrait partiel d'une partie du premier substrat à partir d'une deuxième face du premier substrat, opposée à la première face dudit premier substrat, de sorte à atteindre la première portion de via électrique.

Selon l'invention, on entend par dispositif microélectronique, un dispositif comportant des éléments de dimensions microniques et/ou nanométriques, le dispositif mécaniquement autonome comportant ces éléments étant être de dimensions centimétriques, voire inférieures.

L'invention concerne également un dispositif microélectronique mécaniquement autonome comprenant au moins un via électrique autorisant une connexion électrique à partir d'au moins une première face du dispositif caractérisé en ce qu'un premier substrat comportant une première portion de via électrique exposée à une première face du premier substrat et un deuxième substrat comportant une deuxième portion de via électrique exposée à une première face du deuxième substrat coopèrent à partir d'une interface de collage.

Un effet technique produit par la présente invention est de former un via électrique unitaire présentant un facteur de forme supérieur, à partir de portions de via électrique de substrats différents.

La présente invention permet, en outre, de rendre mécaniquement stable et autonome un dispositif microélectronique comprenant au moins un via électrique. Le procédé selon la présente invention permet notamment de réduire la fragilité, la déformation et la courbure des interposeurs.

### BREVE INTRODUCTION DES FIGURES

Les buts, objets, ainsi que les caractéristiques et avantages de l'invention ressortiront mieux de la description détaillée d'un mode de réalisation de cette dernière, qui est illustré par les dessins d'accompagnement suivants, dans lesquels:
- La figure 1A illustre un dispositif microélectronique comprenant un substrat et une puce selon un procédé connu de l'art antérieur.
- La figure 1B illustre un interposeur, intercalé entre au moins une puce et un substrat, offrant un câblage de sortie entre un petit écart (provenant de la puce) et un grand écart (provenant du substrat).
- La figure 2 illustre un premier substrat comprenant au moins un via électrique.
- La figure 3 illustre l'étape de report du premier substrat sur au moins un deuxième substrat.
- La figure 4 illustre l'étape de retrait partiel d'une partie du premier substrat à partir de la deuxième face du premier substrat, opposée à la première face dudit premier substrat, de sorte à atteindre la première portion dudit via électrique.
- La figure 5 illustre un dispositif microélectronique mécaniquement autonome 10, comprenant au moins un via électrique 50, et utilisable en tant qu'interposeur.
- La figure 6 illustre un dispositif microélectronique mécaniquement autonome 10 offrant un rapport de forme quadruple et possédant des portions de via électrique de diamètres différents.
- La figure 7 illustre un dispositif microélectronique mécaniquement autonome 10 offrant un rapport de forme quadruple et possédant une couche de redistribution 75 sur au moins une première face.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- Le procédé comprend une étape d'assemblage comprenant un collage direct.
- Le procédé comprend une étape de retrait partiel d'une partie du deuxième substrat à partir d'une deuxième face du deuxième substrat, opposée à la première face dudit deuxième substrat, de sorte à atteindre la deuxième portion de via électrique.
- Le procédé comprend la réalisation d'au moins un autre via électrique simultanément audit au moins un via électrique, les vias comprenant un matériau présentant des propriétés thermiques et électriques de sorte à ce que ledit autre via électrique forme un via thermique.
- Le procédé comprend une étape d'assemblage avec au moins un autre substrat sur le premier substrat et/ou le deuxième substrat.
- Le procédé comprend une étape d'assemblage comprenant une étape d'alignement de la première portion de via électrique du premier substrat avec la deuxième portion de via électrique du deuxième substrat.
- Le procédé comprend une étape d'assemblage suivie d'une étape de recuit.
- Le procédé comprend une étape de retrait partiel d'une partie du premier substrat comprenant un polissage.
- Le dispositif comprend une interface de collage direct.
- Le dispositif est configuré pour réaliser un interposeur.
- Le dispositif comprend au moins un via électrique agencé pour réaliser une électrode de capacité.
- Le dispositif comprend une section de la première portion de via électrique du premier substrat égale à la section de la deuxième portion de via électrique du deuxième substrat.
- Le dispositif comprend une section de la première portion de via électrique du premier substrat supérieure à la section de la deuxième portion de via électrique du deuxième substrat.
- Le dispositif comprend au moins un autre via électrique simultanément audit au moins via électrique, les vias comportant un matériau présentant des propriétés thermiques et électriques de sorte à ce que ledit autre via électrique forme un via thermique.
- Le dispositif comprend chaque portion de via ayant une hauteur inférieure à 200 microns et généralement inférieure à 150 microns.
- Le dispositif comprend un diamètre de via électrique inférieur à 20 microns et généralement inférieure à 15 microns.
- Le dispositif comprend le au moins un via électrique en un matériau métallique.
- Le dispositif comprend au moins un substrat est tout ou en partie en un matériau à base de silicium ou de verre.

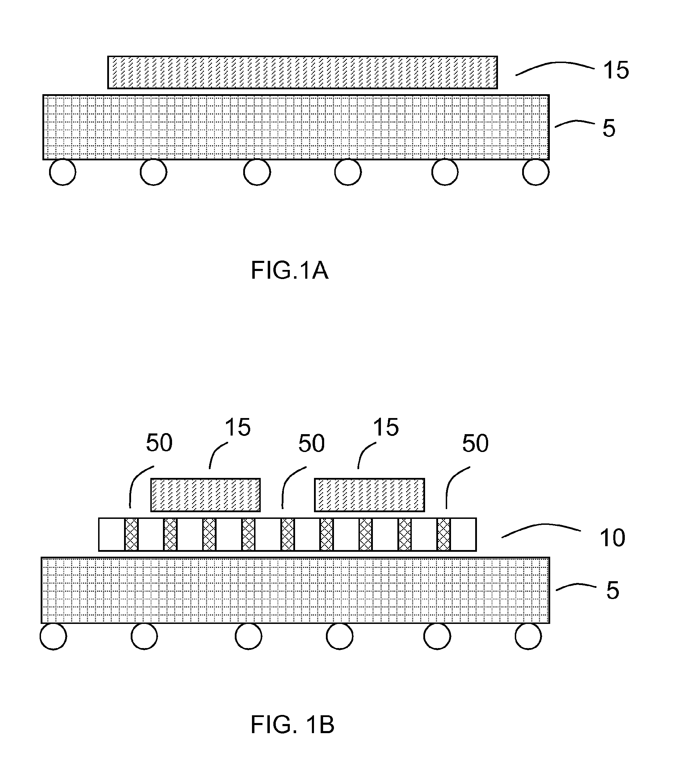

La **figure 1A** illustre un dispositif microélectronique comprenant un substrat 5 et une puce 15. Dans l'art antérieur, il est connu d'utiliser une puce 15, de préférence de silicium retournée sur un substrat 5 organique (ce substrat peut aussi être céramique) ; l'ensemble étant encapsulé dans un « packaging » protecteur par exemple en polymère. La puce 15 de silicium et le substrat 5 sont connectés électriquement en utilisant différentes sortes de technologies émergentes.

Avec la loi de Moore et la réduction des puces 15, les puces deviennent de plus en plus petites alors que le nombre d'interconnexions sur chaque puce 15 est en constante augmentation. Ainsi, la largeur des interconnexions sur les puces 15 actuelles devient de plus en plus petite. Il demeure également difficile de diminuer proportionnellement la largeur des interconnexions sur les substrats 5 notamment organiques. Le substrat 5 organique/céramique est proche d'atteindre, voire a déjà atteint, ses limites en termes de largeur d'interconnexions. En conséquence, il y a un décalage d'échelles dimensionnelles entre les exigences concernant la petite largeur des interconnexions requise sur les puces 15 de silicium actuelles et la limitation sur les substrats 5 nécessitant un large écart des interconnexions.

Une des solutions de l'industrie à ce problème a été le développement d'un interposeur 10, de préférence, de silicium. La **figure 1B** illustre un interposeur 10, intercalé entre au moins une puce 15 de silicium et un substrat 5 organique, offrant un câblage de sortie entre un petit écart (provenant de la puce 15) et un grand écart (provenant du substrat 5). Le signal électrique doit circuler d'une première face de l'interposeur 10 jusqu'à une deuxième face de l'interposeur 10, opposée à la première face, au travers d'au moins un via électrique 50 de silicium de type TSV.

Comme précédemment évoqué, la technologie des vias électriques traversants de type TSV limite l'épaisseur de l'interposeur 10 à environ 200 microns. Au cours du procédé de fabrication standard de l'interposeur 10, une première face de l'interposeur 10 nécessite d'être assemblée à un support temporaire avant que le substrat de l'interposeur 10 soit aminci de sorte à atteindre une épaisseur d'environ 200 à 100 microns, exposant au moins un via électrique 50 à partir de la deuxième face du substrat dudit interposeur 10. L'interposeur 10 actuel n'est donc pas très stable mécaniquement du fait de sa faible épaisseur.

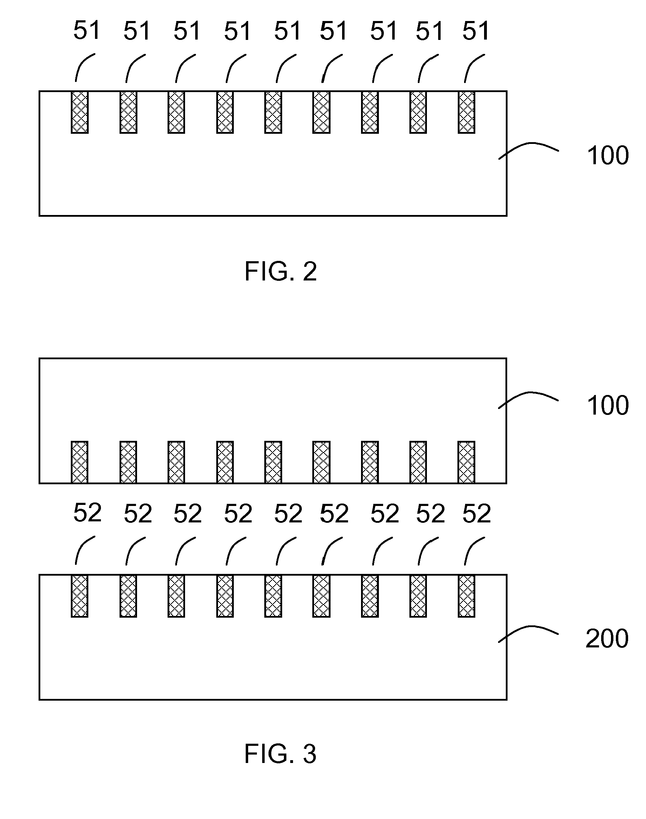

Le procédé qui suit a pour but de réaliser un dispositif microélectronique mécaniquement autonome en référence aux figures 2 à 7. On entend par dispositif mécaniquement autonome, un dispositif autoporteur, utilisable indépendamment d'un autre dispositif et qui se suffit à lui-même d'un point de vue mécanique.

La **figure 2** illustre un premier substrat 100 comprenant au moins une première portion 51 d'au moins un via électrique 50. De préférence, le premier substrat 100 est en un matériau non conducteur ou peu conducteur. Aujourd'hui, la plupart des dispositifs microélectroniques mécaniquement autonomes de type interposeurs 10 sont, de préférence, fabriqués à partir d'un substrat 100 à base de silicium (par exemple, le silicium polycristallin). Cependant, on peut également d'utiliser un substrat 100, tout ou en partie, en polysilicium ou bien un substrat 100 en verre. Le substrat 100 est, de manière particulièrement avantageuse, sous la forme d'une plaque (plus communément dénommée « wafer », en anglais), mais pourra également se présenter sous la forme d'un panneau. De manière particulièrement avantageuse, le premier substrat 100 a une épaisseur comprise entre 100 microns et 1 millimètre.

A titre préféré, la présente invention concerne un mode de réalisation basé essentiellement sur l'utilisation d'au moins un via électrique 50 au travers d'un premier substrat 100 de silicium, plus connu sous le nom sous l'appellation en anglais « Through Silicon Via » ou l'acronyme TSV. Selon un autre mode de réalisation, l'invention peut être appliquée à un via électrique 50 conçu au travers d'un premier substrat 100 en verre, connu sous l'appellation en anglais de « Through Glass Via » ou l'acronyme TGV. Au moins un via électrique 50 est, de manière avantageuse, d'abord formé sur le premier substrat 100.

On entend par via électrique, un composant dirigé suivant l'épaisseur d'un substrat, ou plus généralement d'un dispositif électronique, et qui assure une continuité électrique entre deux niveaux différents suivant l'épaisseur du substrat ou du dispositif. Ces niveaux peuvent être les faces du substrat.

Le via électrique 50 doit pouvoir être isolé électriquement du substrat qu'il traverse en particulier quand ce dernier est conducteur. Une très bonne isolation électrique doit être réalisée afin de prévenir toute fuite de courant entre le conducteur que constitue le via électrique 50 et le substrat. Ainsi, selon un mode de réalisation, une couche diélectrique isolante est formée dans le trou qui aura été crée préalablement dans le substrat pour réaliser le via électrique 50. Il s'ensuit le dépôt d'un fond continu conducteur destiné à, d'une part, rendre possible un remplissage par électrolyse du via électrique 50 et, d'autre part, empêcher au cours de cette opération toute diffusion vers le substrat du matériau conducteur qui va constituer le via électrique 50 en créant une barrière de diffusion.

Le via électrique 50 est conducteur. De manière particulièrement avantageuse, le via électrique 50 comprend du cuivre ou du tungstène. Le via électrique 50 peut cependant être en n'importe quel métal.

Etant donné les exigences électriques requises et le coût de remplissage d'un via électrique 50 en cuivre, la première portion 51 de via électrique 50 formée dans le premier substrat 100 possède une hauteur, inférieure à 200 microns (par exemple 100 microns). La première portion 51 de via électrique 50 possède avantageusement un diamètre compris entre 5 microns et 20 microns, et, à titre préféré, un diamètre pratique de l'ordre de 10 microns.

Selon un mode de réalisation préférentiel, la première portion 51 de via électrique 50 possède une géométrie cylindrique. Selon un autre mode de réalisation, la première portion 51 de via électrique 50 a une forme annulaire. De manière particulièrement avantageuse, les premières portions 51 de vias électriques 50 d'une première face du premier substrat 100 ont toutes la même section, le même diamètre, la même hauteur et la même forme. Selon un mode de réalisation préférentiel, les premières portions 51 de vias électriques 50 du premier substrat 100 sont séparées par un même écart. L'écart entre chaque première portion 51 de vias électriques 50 est, par exemple, compris entre 10 nanomètres et 10 microns.

La **figure 3** illustre l'étape d'assemblage du premier substrat 100 avec au moins un deuxième substrat 200. Le deuxième substrat 200 est préférentiellement en un matériau non conducteur ou peu conducteur. Le deuxième substrat 200 est, de préférence, à base de silicium (par exemple, le silicium polycristallin), polysilicium ou en verre. Avantageusement, le deuxième substrat 200 est sous forme d'une plaque ou d'un panneau. De manière particulièrement avantageuse, le deuxième substrat 200 a une épaisseur comprise entre 100 microns et 1 millimètre.

Le deuxième substrat 200 comprend une deuxième portion 52 d'au moins un via électrique 50. La deuxième portion 52 de via électrique 50 formée dans le deuxième substrat 200 possède une hauteur, de préférence, inférieure à 200 microns (par exemple 100 microns). La deuxième portion 52 de via électrique 50 possède un diamètre compris entre 5 microns et 20 microns, et, à titre préféré, un diamètre pratique de l'ordre de 10 microns.

De manière particulièrement avantageuse, la section de chaque deuxième portion 52 de via électrique 50 de deuxième substrat 200 est identique. L'écart entre chaque deuxième portion 52 de via électrique 50 du deuxième substrat 200 est, de préférence, identique. Selon un mode de réalisation préférentiel, la section de chaque deuxième portion 52 de via électrique 50 du deuxième substrat 200 est égale à la section de chaque première portion 51 de via électrique 50 du premier substrat 100. De manière particulièrement avantageuse, l'écart entre chaque deuxième portion 52 de via électrique 50 du deuxième substrat 200 est identique à l'écart entre chaque première portion 51 de via électrique 50 du premier substrat 100.

De manière générale, il est avantageux que les première 51 et deuxième 52 portions de via électrique 50 aient des emplacements qui coïncident lorsque les premières faces des substrats 100, 200 sont assemblées comme décrit ci-après.

L'étape d'assemblage comprend, à titre préféré, une étape d'alignement de la première portion 51 de via électrique 50 du premier substrat 100 avec la deuxième portion 52 de via électrique 50 du deuxième substrat 200.

La précision du décalage, lors de l'étape d'alignement de la première portion 51 de via électrique 50 du premier substrat 100 avec la deuxième portion 52 de via électrique 50 du deuxième substrat 200, est, par exemple, inférieure à un micron. Le diamètre de chaque portion 51, 52 de via électrique 50 du premier substrat 100 et du deuxième substrat 200 est configuré de sorte à compenser un décalage dans l'alignement de la première portion 51 et de la deuxième portion 52 de via électrique 50, respectivement, du premier substrat 100 et du deuxième substrat 200. Une plus grande tolérance dans le décalage possible de l'alignement permet, de manière particulièrement avantageuse, d'augmenter la cadence de fabrication (A contrario, une grande précision dans l'alignement oblige à ralentir le procédé). Sur un interposeur, le diamètre des interconnexions est généralement plus petit sur la face supérieure que sur la face inférieure, ce qui signifie qu'il est acceptable de former un via électrique 50 dont le diamètre de la première face diffère de celui de la deuxième face, opposée à la première face.

Ceci n'est, de manière particulièrement avantageuse, possible qu'en utilisant une technique d'empilement de portions 51, 52 de via électrique 50 telle que celle utilisée dans la présente invention.

A l'issue de l'étape d'alignement, une étape de collage permanent de la première portion 51 de via électrique 50 du premier substrat 100 avec la deuxième portion 52 de via électrique 50 du deuxième substrat 200 est réalisée.

Dans le domaine des interconnexions, il existe une large palette de technologies à la fois au niveau des contacts électriques eux-mêmes (« solder balls », « copper pillars », liaisons directes cuivre-cuivre, etc.) adaptées aux différents types de contacts électriques (le « pitch », c'est-à-dire la taille des contacts et l'espacement entre ces derniers, varie entre plusieurs centaines de microns et quelques microns), ainsi qu'au niveau de leur redistribution afin de les rendre géométriquement et mécaniquement compatibles avec l'ensemble des opérations ultérieures d'empilement et d'assemblage/collage (« bonding »). Différentes technologies de « bonding » sont proposées de façon à couvrir l'ensemble des spécifications requises par les industriels.

Néanmoins, on aura très préférentiellement recours à une méthode de « direct bonding » permettant le collage direct entre plaques ou entre puces, ne nécessitant ni matériau de collage, ni besoin de chauffage important, ni pression élevée. Cette technologie est basée sur des phénomènes d'adhésion moléculaire entre les atomes des deux surfaces en regard. Le collage direct n'a encore jamais été utilisé comme une technologie permettant de construire des interposeurs mécaniquement stables et compatibles avec les chaînes de réapprovisionnement.

De manière particulièrement avantageuse, le premier substrat 100 est reporté sur le deuxième substrat 200 à partir de la première portion 51 de via électrique 50 du premier substrat 100 et de la deuxième portion 52 de via électrique 50 du deuxième substrat 200, par un collage à la fois mécanique et électrique. La première portion 51 de via électrique 50 du premier substrat 100 et la deuxième portion 52 de via électrique 50 du deuxième substrat 200 sont alignées de telle manière que l'alignement du premier substrat 100 et du deuxième substrat 200 crée au moins un via électrique 50 continu, tout en doublant efficacement la longueur du via électrique 50. Un exemple de réalisation a permis de démontrer une tolérance d'alignement inférieure à un micron avec des plots de contacts d'une surface de 5µm² (ce qui est nettement inférieur aux 10 microns de diamètre des vias électriques actuels de type TSV). La résistance de contact est négligeable comparée à la résistance des vias électriques traversants.

Selon un mode de réalisation préférentiel, l'étape d'assemblage comprend un collage direct qui est un type de collage permanent. On entend par « collage direct », un assemblage de substrats 100, 200 réalisé de sorte à ce que les substrats 100, 200 soient solidarisés entre eux une fois leur mise en contact ; ledit assemblage ne nécessitant avantageusement le recours d'aucun moyen intermédiaire. On appelle « collage permanent », un collage rendant possible une adhésion permanente d'un substrat à un autre substrat, par exemple. Il est possible de réaliser, de préférence, un collage direct d'une première portion 51 de via électrique 50 d'un premier substrat 100 avec une deuxième portion 52 de via électrique 50 d'un deuxième substrat 200 à partir de vias électriques 50, de préférence en cuivre, présents sur lesdits premier substrat 100 et deuxième substrat 200, en permettant un collage à la fois mécanique et électrique entre les première et deuxième portions 51, 52 de vias électriques 50.

Les interfaces de collages entre la première portion 51 de via électrique 50 du premier substrat 100 et la deuxième portion 52 de via électrique 50 du deuxième substrat 200 ont, de manière surprenante, été mesurées comme étant mécaniquement solides, de faible résistance électrique et fiables. Le concept peut, de manière particulièrement avantageuse, être extrapolé à d'autres substrats 100, 200 ou conducteurs.

Le procédé selon l'invention autorise le recours à toutes les formes de collage permanent sur tout type de support. Le collage peut être de type « silicon direct bonding ». Selon cet exemple de réalisation, les supports 100, 200 pour l'assemblage sont de type Silicium/Silicium. A titre préféré, les surfaces de chacun des supports 100, 200 destinés à être assemblés comprennent de l'oxyde de silicium (SiO₂). Selon d'autres modes de réalisation non limitatifs de l'invention, les assemblages verre/verre, métal/métal ou oxyde métallique /oxyde métallique pour les matériaux conducteurs sont également réalisables. Ainsi, le procédé selon l'invention comprend une étape de report par collage direct, ou collage moléculaire. Les techniques de collage de substrats font partie des procédés de fabrication des dispositifs microélectroniques. Cependant, les techniques de collage de substrats requièrent généralement l'utilisation d'une couche adhésive intermédiaire, telle qu'une résine, un polymère ou une couche métallique, par exemple, intercalée entre les substrats.

La présente invention, de manière particulièrement avantageuse, ne nécessite pas l'emploi d'une couche intermédiaire entre le premier substrat 100 et le deuxième substrat 200.

L'étape de collage est, de préférence, suivie d'un recuit. Le recuit favorise la fusion locale du matériau formant le via électrique 50. Le recuit a l'avantage de renforcer les forces de collage entre le premier substrat 100 et le deuxième substrat 200. De manière particulièrement avantageuse, cette étape de recuit de consolidation du scellement entre un premier substrat 100 et un deuxième substrat 200, peut se faire après chaque report et/ou après la formation de l'empilement des différents substrats 100, 200 reportés. Selon un mode de réalisation avantageux, la présente invention peut être appliquée à un substrat 100, 200, organique de faible épaisseur. Dans ce cas, le matériau organique devra résister aux températures de recuit du cuivre, formant le via électrique 50, qui avoisinent les 400°C. Avantageusement, la température de recuit est choisie de sorte à améliorer la liaison mécanique ainsi que le contact électrique au niveau de l'interface entre les portions de via électrique 50. De manière particulièrement avantageuse, la présence même faible d'oxydes sur la surface métallique des portions de via électrique 50 permet d'accroître le contact électrique, sans toutefois nécessiter de dépasser une température de transition vitreuse. Les gammes de températures utilisées pour le recuit varient en fonction de la présence d'oxydes sur la surface métallique des portions de via électrique 50 ainsi que des matériaux utilisés pour lesdites portions de via électrique 50. Avantageusement, la température de recuit est comprise entre 0°C et 1000°C, et préférentiellement comprise entre 100°C et 800°C. Selon un mode de réalisation particulier comprenant du cuivre, la température optimale de recuit est préférentiellement comprise entre 100°C et 400°C. De manière particulièrement avantageuse, la température de recuit est sélectionnée de sorte à, d'une part consolider le collage direct et, d'autre part, favoriser le scellement des matériaux conducteurs des vias.

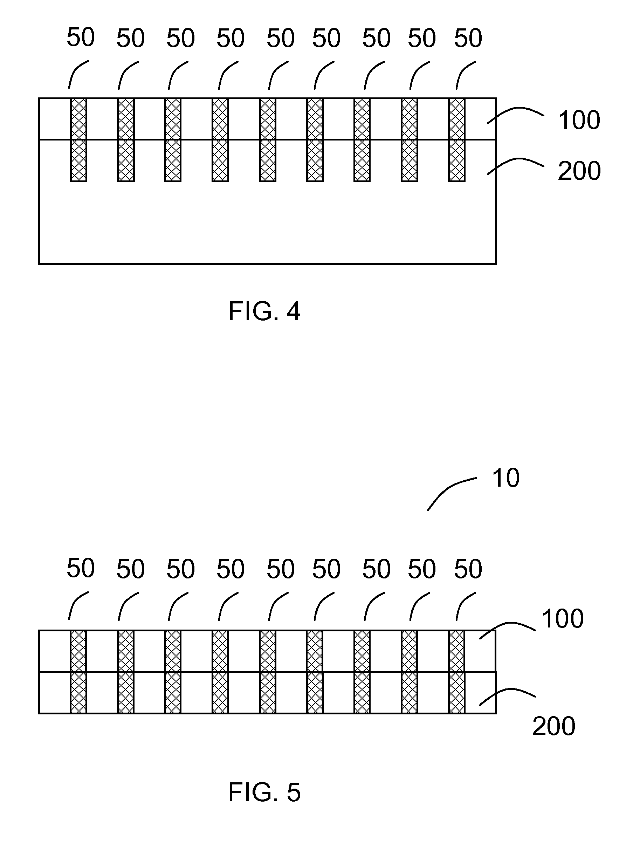

La **figure 4** illustre l'étape de retrait partiel d'une partie du premier substrat 100 à partir de la deuxième face du premier substrat 100, opposée à la première face dudit premier substrat 100, de sorte à atteindre la première portion 51 de via électrique 50. De manière particulièrement avantageuse, l'étape de retrait partiel d'une partie du premier substrat 100 comprend un polissage. Le polissage d'une partie du premier substrat 100 est, de préférence, un polissage (ou planarisation) mécano-chimique (acronyme CMP en anglais pour « Chemical Mechanical Planarization » ou « Chemical Mechanical Polishing ». Ce processus aplanit par exemple les reliefs sur les couches d'oxydes de silicium, de poly-silicium ainsi que les couches métalliques. Il est utilisé pour planariser ces couches afin de les préparer aux étapes lithographiques suivantes, évitant ainsi les problèmes de mise au point liés aux variations de profondeur lors de l'illumination de la résine photosensible.

Cette étape de retrait partiel d'une partie du premier substrat 100 est une planarisation utilisée pour l'amincissement dudit substrat 100. Cette étape consiste donc à amincir le premier substrat 100 à partir de la deuxième face de sorte à atteindre la première portion 51 de via électrique 50. L'étape de retrait partiel d'une partie du premier substrat 100 s'arrête dès lors que la première portion 51 de via électrique 50 est atteinte. Selon un mode de réalisation préférentiel, l'étape de retrait partiel d'une partie du premier substrat 100 s'arrête dès qu'un accroissement du couple résistant est détecté. Dans ce cas particulier, l'action mécanique du polissage mécano-chimique permet de polir en protrusion le matériau de la première portion 51 de via électrique 50, car le taux d'ouverture est très faible (inférieur à 1%); le taux d'ouverture correspondant à la surface en protrusion divisée par la surface totale de la plaque. Lorsque les protrusions sont polies, le matériau formant la première portion 51 de via électrique 50 représente alors la quasi-intégralité de la surface de la plaque, et la vitesse de polissage devient, dès lors, très faible. La première portion 51 de via électrique 50 devient une couche d'arrêt à l'étape de polissage mécano-chimique. En outre, l'écart entre chaque via électrique 50 réalisé sur le premier substrat 100 est configuré de sorte à favoriser un meilleur contrôle de l'arrêt du polissage mécano-chimique.

Avantageusement, à l'issue de cette étape de retrait partiel d'une partie du premier substrat 100, la deuxième face du premier substrat 100 est complètement planarisée avec des portions 51 de vias électriques 50 affleurant la surface.

De manière particulièrement avantageuse, on obtient un empilement du premier substrat 100 et du deuxième substrat 200 formant au moins un via électrique 50 présentant un facteur de forme deux fois meilleur que le rapport de forme originel car comprenant la première portion 51 du premier substrat 100 et la deuxième portion 52 du deuxième substrat 200.

Il a été constaté que la résistance de contact entre les contacts de cuivre est négligeable comparée à la résistance déjà acceptable de vias électriques 50 de type TSV ou TGV. Il a également été observé par expérimentation que la fiabilité d'électro-migration n'est pas dominée par l'interface de collage. En d'autres termes, une performance électrique similaire à celle d'un fil de cuivre d'environ 10 microns de diamètre, par exemple, est obtenue.

A l'issue de l'étape de retrait partiel d'une partie du premier substrat 100, on obtient un dispositif microélectronique mécaniquement autonome formant, par exemple, une électrode de capacité à partir d'un via électrique 50 possédant au moins un facteur de forme double dans un cas conventionnel ; cela grâce au report d'une première portion du premier substrat 100 sur la deuxième portion du via électrique du deuxième substrat 200. La réalisation de capacités par la superposition de portions 51, 52 de via électrique 50 permet de manière particulièrement avantageuse d'obtenir des capacités de grandes profondeurs et d'améliorer ainsi leur capacitance. Grâce aux avantages liés aux techniques de collage direct, un passage de faible résistance électrique peut être fait au travers du via électrique 50 formé par la première et la deuxième portions 51, 52.

Le procédé peut, à titre préféré, être répété jusqu'à obtenir un empilement d'une pluralité de substrats 100, 200 d'épaisseur suffisante pour qu'une stabilité mécanique soit obtenue. Dans ce cas, l'empilement se fera à partir de la deuxième face de l'un des substrats, ladite face ayant préalablement été polie, de préférence, par polissage mécano-chimique afin d'exposer une portion 51, 52 de via électrique 50. Avantageusement, les portions 51, 52 de via électrique 50 affleurent la surface à l'issue des étapes de polissage mécano-chimique. Ces étapes de polissage permettent avantageusement de planariser la surface et favorisent une uniformité. Les portions de via électrique 50 affleurent la surface. L'assemblage de substrats 100, 200 par collage est amélioré et privilégie une meilleure liaison mécanique entre les substrats 100, 200 ainsi qu'un meilleur contact électrique entre les portions 51, 52 de via électrique 50 affleurant la surface.

La **figure 5** illustre un dispositif microélectronique mécaniquement autonome 10, comprenant au moins un via électrique 50, et utilisable en tant qu'interposeur. De manière particulièrement avantageuse, le dispositif microélectronique mécaniquement autonome 10 comprenant au moins un via électrique 50 autorise une connexion électrique à partir d'au moins une première face du dispositif. Préférentiellement, un premier substrat 100 comportant une première portion 51 de via électrique 50 exposée à une première face du premier substrat 100 et un deuxième substrat 200 comportant une deuxième portion 52 de via électrique 50 exposée à une première face du deuxième substrat 200 coopèrent à partir d'une interface de collage.

De manière particulièrement avantageuse, le procédé selon la présente invention permet d'au moins doubler efficacement le facteur de forme du via électrique 50. Dès lors, ce dispositif microélectronique mécaniquement autonome 10 a une structure qui est mécaniquement plus stable que la version originelle, car étant plus épaisse. Si le dispositif 10 est déjà suffisamment épais, ou suffisamment stable mécaniquement, il peut dès lors être utilisé comme tel pour des étapes de traitement standard supplémentaires.

Selon un mode de réalisation préférentiel, l'empilement de portions 51, 52 de via électrique 50 provenant d'une pluralité de substrats 100, 200, continue de la même manière jusqu'à atteindre une épaisseur spécifique du dispositif microélectronique mécaniquement autonome 10 c'est-à-dire une longueur définie du via électrique 50.

Selon un autre mode de réalisation, deux empilements de deux substrats supplémentaires comprenant au moins un via électrique 50 et un double facteur de forme sont assemblés par collage pour former au moins un via électrique 50 possédant un quadruple facteur de forme.

Selon encore un autre mode de réalisation, un substrat comprenant au moins un via électrique 50 est empilé sur un empilement de substrats comprenant au moins un via électrique 50 pour former 3x, 4x, 5x, ..., nx portions du via électrique 50, avec un facteur de forme du via électrique 50 n fois meilleur que celui normalement possible.

L'épaisseur du dispositif microélectronique mécaniquement autonome final peut être contrôlée en déterminant le facteur de forme final du via électrique 50, qui à son tour peut être contrôlé par le nombre de portions du via électrique 50 empilées.

Dans le cas d'un substrat de silicium de 300 millimètres de diamètre, il semblerait satisfaisant qu'un dispositif microélectronique mécaniquement autonome possède une épaisseur d'environ 400 microns. Avec la technologie actuellement utilisée de vias électriques de type TSV, il faudrait donc avoir recours à un empilement de quatre substrats comprenant au moins un via électrique 50. Dans le cas d'un substrat de silicium de 200 millimètres de diamètre, un dispositif microélectronique mécaniquement autonome pourrait posséder une épaisseur d'environ 300 microns. Avec la technologie actuellement utilisée de vias électriques, il faudrait avoir recours à un empilement de trois substrats comprenant au moins un via électrique 50. Cependant, avec les améliorations du facteur de forme des vias électriques traversants de type TSV ou TGV, le nombre de substrats dans les deux cas pourrait être réduit.

De manière particulièrement avantageuse, l'ordre de l'empilement peut varier. L'empilement de portions 51, 52 de via électrique 50 est, selon un mode de configuration préférentiel, réalisé à partir de la première face du substrat pourvue de portions 51, 52 de via électrique 50. L'empilement de portions 51, 52 de via électrique 50 est, selon un autre mode de réalisation, formé à partir de la deuxième face du substrat, polie de sorte à faire apparaître le via électrique 50.

De manière particulièrement avantageuse, au moins un substrat de l'empilement de portions 51, 52 de via électrique 50 comprend un matériau semi-conducteur, organique ou en verre. Selon un autre mode de réalisation, les différents substrats de l'empilement de portions 51, 52 de via électrique 50 sont tous en un matériau semi-conducteur, organique ou en verre.

Selon un mode de réalisation où plus de deux substrats sont empilés, le principe de compensation d'un décalage d'alignement fonctionne également.

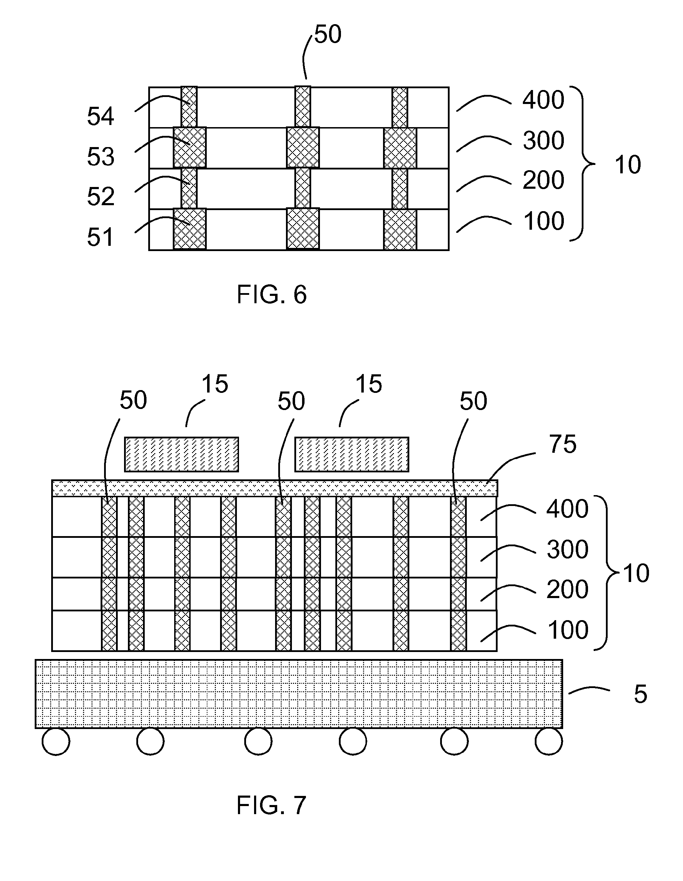

La **figure 6** illustre un cas de configuration où le dispositif microélectronique mécaniquement autonome 10 est formé de l'empilement de quatre substrats 100, 200, 300, 400. Le via électrique 50 est avantageusement formé par collage direct d'une première portion 51, d'une deuxième portion 52, d'une troisième portion 53 et d'une quatrième portion 54 de via. Suivant une alternative, les première, deuxième, troisième et quatrième portions 51, 52, 53, 54 de via électrique 50 ont un même axe longitudinale suivant l'épaisseur des substrats 100, 200, 300, 400. La deuxième portion 52 de via électrique 50 du deuxième substrat 200 a un diamètre supérieur à celui de la première portion 51 et de la troisième portion 53 de via électrique 50 des premier et troisième substrats 100, 300 respectivement.

Selon un autre exemple de réalisation, le via électrique 50 peut être formé d'un empilement de portions 51, 52, 53, 54 de via électrique 50 dont le diamètre de chaque portion 51, 52, 53, 54 augmente ou décroit progressivement depuis une première face du via électrique 50 jusqu'à une deuxième face du via électrique 50.

La figure 7 illustre un dispositif microélectronique mécaniquement autonome 10 offrant avantageusement un facteur de forme quadruple suite à l'empilement de quatre substrats 100, 200, 300, 400 pourvus de portions 51, 52, 53, 54 de vias électriques 50. Le dispositif microélectronique mécaniquement autonome 10 possède, de préférence, une couche de redistribution 75 sur au moins une première face. La couche de redistribution 75 comporte généralement un empilement de couches dont au moins une couche conductrice électrique, structurée. Cette couche de redistribution peut bien entendu être utilisée dans la figure 1B bien que non représentée. De façon plus générale une couche de redistribution 75 peut-être utilisée sur chacune des deux faces du dispositif microélectronique mécaniquement autonome 10. Elle peut être déposée, de préférence, sur la première face du dispositif microélectronique mécaniquement autonome 10 où est exposé au moins un via électrique 50; le dispositif microélectronique mécaniquement autonome 10 étant fabriqué selon le procédé de la présente invention. De manière particulièrement avantageuse, la couche de redistribution 75 peut être déposée sur la première face et sur la deuxième face, opposée à la première face, du dispositif microélectronique mécaniquement autonome 10, faces sur lesquelles est exposé au moins un via électrique 50.

Alors que le principal intérêt des interposeurs est de fournir une redistribution de câblage entre des interconnexions de puces de faible largeur et un substrat 5, de préférence, organique, très large, un avantage additionnel est que la présence d'une couche de redistribution 75 sur le dispositif microélectronique mécaniquement autonome 10 permet également l'empilement côte-à-côte de puces 15. Cela permet des connexions verticales raccourcies et plus rapprochées directement entre les puces 15 autorisant une meilleure bande passante et de plus grandes vitesses de transmission, avantages qu'on attend d'une intégration 3D classique. La présente invention concerne avantageusement tous les procédés d'intégration 3D.

Selon un mode de réalisation représenté sur la figure 6, l'écart entre chaque via électrique 50 d'un même substrat 100, 200, 300, 400 varie. De manière particulièrement avantageuse, l'écart entre chaque portion 51 de via électrique 50 d'un premier substrat 100 est configuré de sorte à correspondre à l'écart entre chaque portion 52, 53, 54 de via électrique 50 des autres substrats 200, 300, 400 de l'empilement. De manière particulièrement avantageuse, l'écart entre chaque via électrique 50 réalisé sur un même substrat 100, 200, 300, 400 est configuré de sorte à préserver sur chacune des faces du substrat 100, 200, 300, 400 une proportion de matériau que comprend le substrat suffisante pour garantir le collage direct avec au moins un autre substrat 100, 200, 300, 400.

Dans un cas optionnel, le procédé est standardisé de sorte à produire à l'identique des substrats 100, 200, 300, 400 avec des portions 51, 52, 53, 54 de via électrique 50.

Il existe une quantité d'applications pour les dispositifs microélectroniques mécaniquement autonomes 10. Toute application requérant un interposeur traditionnel peut bénéficier d'un dispositif microélectronique stable mécaniquement 10 comme celui de la présente invention.

Une application possible pour ce dispositif microélectronique mécaniquement autonome 10 est, par exemple, le « packaging » consistant en l'assemblage des puces 15 pouvant être optimisé par un procédé d'interconnexion plus court (donc plus efficace et plus rapide) et ainsi conduire à des systèmes plus compacts. Dans ce cas, l'interposeur a avantageusement trois fonctions : réacheminement des connexions des puces 15 vers la connexion au substrat 5, amélioration du rendement en réduisant la surface des puces 15 (par exemple, quatre puces 15 par package au lieu de une) et l'intégration hétérogène c'est-à-dire l'empilement de différentes technologies dans le même package de silicium.

La présente invention permet l'augmentation du facteur de forme de vias électriques 50 par collage permanent en général, et plus spécifiquement par collage direct, rendant possible une utilisation dans les procédés d'intégration 3D classiques. La présente invention permet de rendre mécaniquement stable et autonome un dispositif microélectronique 10 comprenant au moins un via électrique 50. Celle-ci permet notamment de réduire la fragilité, la déformation et la courbure des interposeurs.

La présente invention permettra d'éviter le recours à la manipulation de matériaux très fins. Tout au long du procédé de fabrication, un substrat très fin n'est jamais requis. Le dispositif microélectronique mécaniquement autonome 10 final peut être aussi fin (ou épais) que requis pour éliminer complètement le stress lié à la courbure ou la déformation dudit dispositif.

La présente invention n'est pas limitée aux modes de réalisation précédemment décrits mais s'étend à tout mode de réalisation conforme à son esprit. L'invention n'est, en particulier, pas limitée à des interposeurs et s'applique à tout type de dispositif microélectronique mécaniquement autonome.

L'invention n'est pas non plus limitée à la réalisation de via électrique servant uniquement de connexion électrique. Le procédé peut en effet comprendre la réalisation d'au moins un autre via électrique simultanément audit au moins un via électrique, les vias comprenant un matériau présentant des propriétés thermiques et électriques de sorte à ce que ledit autre via électrique (50) forme un via thermique. Le via thermique est avantageusement apte à conduire la chaleur et ne peut pas être utilisé pour former une connexion électrique. Les vias thermiques et les vias électriques sont identiques dans leur structure mais pas dans leur fonction.

## Revendications

1. Procédé de réalisation d'un dispositif microélectronique mécaniquement autonome (10) comprenant au moins un via électrique (50) autorisant une connexion électrique à partir d'au moins une première face du dispositif **caractérisé en ce qu'**il comprend la séquence d'étapes suivantes :
- A partir d'un premier substrat (100) comportant une première portion (51) de via électrique (50) exposée à une première face du premier substrat (100), et d'un deuxième substrat (200) comportant une deuxième portion (52) de via électrique (50) exposée à une première face du deuxième substrat (200), une étape de report du premier substrat (100) sur le deuxième substrat (200), par collage direct de leurs premières faces de sorte à ce que la première portion (51) et la deuxième portion (52) de via électrique (50) soient en continuité électrique,
- une étape de retrait partiel d'une partie du premier substrat (100) à partir d'une deuxième face du premier substrat (100), opposée à la première face dudit premier substrat (100), de sorte à atteindre la première portion (51) de via électrique (50).

2. Procédé selon l'une quelconque des revendications précédentes comprenant une étape de retrait partiel d'une partie du deuxième substrat (200) à partir d'une deuxième face du deuxième substrat (200), opposée à la première face dudit deuxième substrat (200), de sorte à atteindre la deuxième portion (52) dudit via électrique (50).

3. Procédé selon l'une quelconque des revendications précédentes comprenant la réalisation d'au moins un autre via électrique (50) simultanément audit au moins un via électrique (50), les vias comprenant un matériau présentant des propriétés thermiques et électriques de sorte à ce que ledit autre via électrique (50) forme un via thermique.

4. Procédé selon l'une quelconque des revendications précédentes comprenant au moins une étape de report d'au moins un autre substrat sur le premier substrat (100) et/ou le deuxième substrat (200).

5. Procédé selon l'une quelconque des revendications précédentes dans lequel l'étape de report du premier substrat (100) sur le deuxième substrat (200) comprend une étape d'alignement de la première portion (51) de via électrique (50) du premier substrat (100) avec la deuxième portion (52) de via électrique (50) du deuxième substrat (200).

6. Procédé selon l'une quelconque des revendications précédentes dans lequel l'étape de report du premier substrat (100) sur le deuxième substrat (200) est suivie d'une étape de recuit.

7. Procédé selon l'une quelconque des revendications précédentes dans lequel l'étape de retrait partiel d'une partie du premier substrat (100) et/ou d'une partie du deuxième substrat (200) comprend un polissage.

8. Dispositif microélectronique mécaniquement autonome (10) comprenant au moins un via électrique (50) autorisant une connexion électrique à partir d'au moins une première face du dispositif (10) **caractérisé en ce qu'**un premier substrat (100) comportant une première portion (51) de via électrique (50) exposée à une première face du premier substrat (100) et un deuxième substrat (200) comportant une deuxième portion (52) de via électrique (50) exposée à une première face du deuxième substrat (200), le via électrique (50) comportant ladite première et ladite deuxième portions (51, 52) en contact électrique à partir d'une interface de collage, dans lequel l'interface de collage est une interface de collage direct.

9. Dispositif selon la revendication 8 dans lequel le dispositif est configuré pour réaliser un interposeur.

10. Dispositif selon l'une quelconque des revendications précédentes 8 à 9 dans lequel au moins un via électrique (50) est agencé pour réaliser une électrode de capacité.

11. Dispositif selon l'une quelconque des revendications précédentes 8 à 10 dans lequel la section de la première portion (51) de via électrique (50) du premier substrat (100) est égale à la section de la deuxième portion (52) de via électrique (50) du deuxième substrat (200).

12. Dispositif selon l'une quelconque des revendications précédentes 8 à 10 dans lequel la section de la première portion (51) du via électrique (50) du premier substrat (100) est supérieure à la section de la deuxième portion (52) de via électrique (50) du deuxième substrat (200).

13. Dispositif selon l'une quelconque des revendications précédentes 8 à 12 comprenant au moins un autre via électrique (50) simultanément audit au moins via électrique (50), les vias comportant un matériau présentant des propriétés thermiques et électriques de sorte à ce que ledit autre via électrique (50) forme un via thermique.

14. Dispositif selon l'une quelconque des revendications précédentes 8 à 13 dans lequel chaque portion de via électrique (50) possède une hauteur inférieure à 200 microns et généralement inférieure à 150 microns.

15. Dispositif selon l'une quelconque des revendications précédentes 8 à 14 dans lequel le diamètre du via électrique (50) est inférieur à 20 microns et généralement inférieur à 15 microns.

16. Dispositif selon l'une quelconque des revendications précédentes 8 à 15 dans lequel le au moins un via électrique (50) est en un matériau métallique.

17. Dispositif selon l'une quelconque des revendications précédentes 8 à 16 dans lequel au moins un substrat (100, 200) est tout ou en partie en un matériau à base de silicium ou de verre.
